# EUROPEAN PATENT APPLICATION

(11) **EP 2 315 379 A2**
(43) Date of publication of application: **27.04.2011**
(21) Application number: 10184735.8
(22) Date of filing: 23.04.2003
(51) Int. Cl.: H04J 3/00, H04J 3/24, H03M 13/27, H04L 1/00

(54) **System and method for data transmission and reception**

(30) Priority: 05.03.2003 US 382334
(62) Divisional of application: 03728514.5
(71) Applicant: Nokia Corporation, 02150 Espoo (FI)
(72) Inventor: Pekonen, Harri, 21260, Raisio (FI); Vesma, Jussi, FIN-20320, Turku (FI)
(74) Representative: Piotrowicz, Pawel Jan Andrzej

(57) **Abstract**

*A method for data transmission comprising, placing one or more data segments into a two-dimensional structure (103) having first data arrangement and second data arrangement which are perpendicular to each other and placement is with respect to first directional arrangements, adding to each second directional arrangements one or more corresponding characteristic values (107), transmitting the contents of one or more first directional arrangements that hold portions of characteristic values, and transmitting the one or more data segments.*

## Description

### Field of Invention

This invention relates to systems and methods for data transmission and reception.

### Background Information

Services used in mobile handheld terminals require relatively low bandwidth. The estimated maximum bitrate for streaming video using advanced compression like MPEG-4 is in the order of few hundred kilobits per second, one practical limit being 384 kbps coming from the 3G environment. Some other types of services, as file downloading, may require significantly higher bandwidth, though. Therefore we have requirement for flexibility.

A DVB transmission system usually provides bandwidth of 10 Mbps or more. This provides a possibility to significantly reduce the average DVB receiver power consumption by introducing a schema based on time division multiplexing (TDM). The introduced schema is called time slicing.

The idea of time slicing is to send.data in bursts using significantly higher bandwidth compared to the bandwidth required if the data was transmitted using static bandwidth. Within a burst, time to the beginning of the next burst (delta-t) is indicated. Between the bursts, data of the service is not transmitted, allowing other services to use the bandwidth otherwise allocated for the service. This enables a receiver to stay active only a fragment of the time, while receiving bursts of a requested service. In case a constant lower bitrate is required by the mobile handheld terminal, this may be provides by buffering the received bursts.

As an extra benefit, time slicing also supports the possibility to use the receiver to monitor neighboring cells during the off-times. And by accomplishing the switching of the reception from transport stream to another during an off period, the reception of a service is seemingly uninterrupted. In a normal DVB-T systems a smooth hand-over would require two front-ends in a single terminal.

The data is formatted by using, for example, a multi-protocol encapsulator in accordance with Section 7 of European Standard EN 301 192 "Digital Video Broadcasting (DVB); DVB specification for data broadcasting." Encapsulated data is sent by the multi-protocol encapsulator to a digital broadcast transmitter for broadcast to the digital broadcast receiver as a time-slicing signal. The time-slicing signal comprises a continuous series of transmission bursts.

It is noted that further information regarding DVB may be found, for example, in the following ETSI (European Telecommunications Standards Institute) documents, each of which is incorporated herein by reference:
ETSI TR 101202 Digital Video Broadcasting (DVB)
"Implementation guidelines for Data Broadcasting"
ETSI EN 300468 Digital Video Broadcasting (DVB)
"Specification for Service Information (SI) in DVB systems"
ETSI EN 300 744 "Digital Video Broadcasting (DVB)
Framing structure, channel coding and modulation for digital terrestrial television"

In recent years, there has been an increase in the use of the use of wired and wireless networks for various purposes. For example, networks are increasingly used for the transmission and reception of, for example, media, applications, and personal communications. In view, for example, of this increased use, there may be interest in technologies applicable to such networks.

### Summary of the Invention

According to various embodiments of the present invention, there are provided systems and methods wherein a two-dimensional array or the like is employable in data transmission and/or reception. Further according to various embodiments of the present invention, characteristic values are computable with respect to data to be transmitted, and transmittable along with that data. Such characteristic values could be used by a data recipient, and could include, for instance, forward error correction (FEC) data or other channel encoding data.

Embodiments of the present invention are employable for a number of network types including, for example, Digital Video Broadcast (DVB) networks.

Various embodiments of the present invention provide interleaving for original data as well as for the characteristic values such as FEC data or other channel encoding data (e.g., Reed-Salomon encoding data), which interleaving is not limited only to higher layer interleaving as the encoding is done perpendicular to the packets or the like, the packets or the like perhaps comprising burst data. In conventional DVB systems, interleaving is done at a lower layer.

Further, embodiments of the present invention can easily be implemented for time-slicing systems, as there is already memory available in the transmitters and the receivers. No extra memory is needed and no extra delay is introduced. In time-slicing receivers, the received burst is stored before any operations are made to the data.

It is noted that, in accordance with various embodiments of the present invention, packets or the like corresponding to data to be transmitted may be passed intact without interleaving, while corresponding characteristic values (e.g., FEC data) may be interleaved.

Various embodiments of the present invention are "backward compatible", as the characteristic values (e.g., FEC data) can be discarded and the original data is not interleaved, whether or not the characteristic values are transmitted in a separate burst.

It is further noted that embodiments of the present invention comply with various requirements for positioning interleaving and de-interleaving.

### Brief Description of the Drawings

Fig. 1 is a diagram depicting exemplary steps involved in data transmission according to embodiments of the present invention.
Fig. 2 is a diagram depicting exemplary steps involved in data reception according to embodiments of the present invention.
Fig. 3 is a diagram depicting a first loading technique according to embodiments of the present invention.
Fig. 4 is a diagram depicting a second loading technique according to embodiments of the present invention.
Fig. 5 shows an exemplary general purpose computer employable in embodiments of the present invention.
Fig. 6 shows a functional block diagram of an exemplary node employable in embodiments of the present invention.

### Detailed Description of the Invention

### General Operation

There are provided, according to various embodiments of the present invention, systems and methods for data transmission and reception. According to various exemplary embodiments, a two-dimensional array or the like of addressable storage locations could be created and/or accessed by a transmitting node.

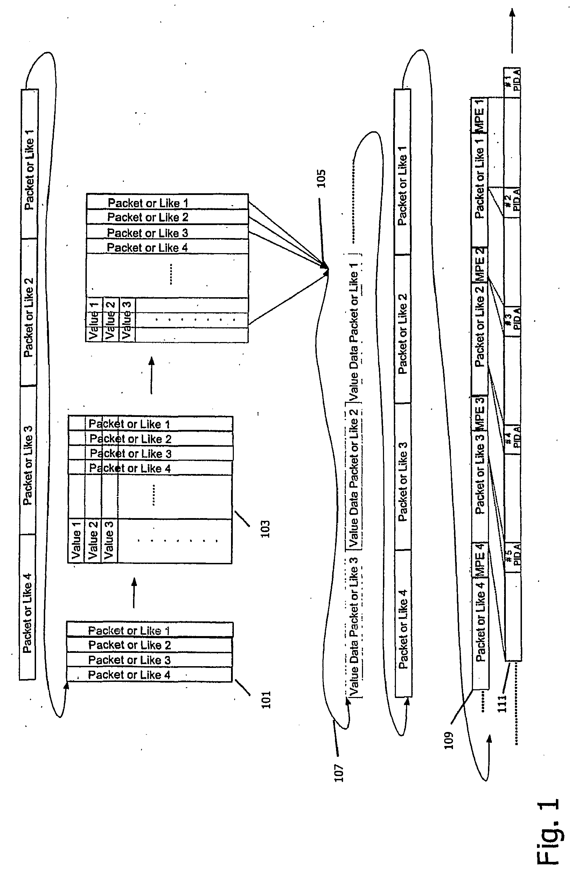

Turning to Fig. 1, it is noted that in such embodiments, packets or the like corresponding to data to be transmitted by the node, perhaps in a particular burst, could be loaded into the two-dimensional array or the like in a columnar-wise manner (step 101). Such packets or the like might be, for instance, Internet Protocol (IP) packets. Accordingly, the contents of a loaded packet or the like could occupy one or more addressable storage locations of one or more columns.

Next, one or more characteristic values could be computed with respect to each row of the two-dimensional array or the like (step 103). Such characteristic values might, for example, express forward error correction (FEC) data. As a specific example, such FEC data might be Reed-Solomon error correction data. A computed characteristic value corresponding to a row could next be stored so as to be appended to that row. Accordingly, the characteristic value could occupy one or more addressable storage locations of that row.

It is noted that, in various embodiments, the manner in which characteristic values were computed could vary dynamically. As a specific example, where characteristic values corresponded to FEC data (e.g., Reed-Solomon data), the amount of parity data to be added could vary dynamically. For instance, more parity data could be added where network conditions arose that were expected to result in greater transmission error.

As a next step, the two-dimensional array or the like could be emptied in a columnar-wise manner (step 105). In such emptying, the originally-loaded packets or the like could be extracted. In various embodiments, each originally-loaded packet might be modified by the node so as to include an indication of where it was stored in the array or the like. The indication might, for instance, state the row and/or column address corresponding to the first addressable storage location that was occupied by the packet or the like.

Such an indication might, for instance, be stored in a header corresponding to the packet or the like. The indication corresponding to a packet or the like might, for example, be added to that packet or the like by the node soon after the node placed it in the array or the like. As another example, the node might place the indication soon before unloading the packet from the array or the like.

Further in the columnar-wise emptying, data corresponding to computed characteristic values could be unloaded and placed into one or more packets or the like (step 107). The one or more packets or the like could, for example, be IP packets. Such a packet could, for example, contain all of the data corresponding to computed characteristic values stored in a particular column of the array or the like. Accordingly, such a packet could contain data corresponding to more than one characteristic value. For example, such a packet could contain portions of the data corresponding to each of one or more certain characteristic values. It is noted that the data corresponding to a particular characteristic value could be dispersed among more than one of such packets. In various embodiments, appended to such a packet could be an indication of where the data it held was stored in the array or the like. The indication might, for instance, state the column address corresponding to the first addressable storage location that was occupied by the held data,

Next, the node could take steps to transmit to one or more recipient nodes the created packets or the like holding characteristic values or parts thereof and the, perhaps modified, originally-loaded packets or the like. It is noted that, in various embodiments, the created packets or the like holding characteristic values could be dispatched in a separate burst from the, perhaps modified, originally-loaded packets or the like. In various embodiments of the invention, the characteristic values or parts thereof could be added to the, perhaps modified, originally-loaded packets or the like.

In certain embodiments of the invention, one or more of the columns of data holding characteristic values might not be transmitted. When the characteristic values are parity data of Reed-Solomon code, the omission of data columns might, for instance, correspond to a puncturing of the RS code. The number of columns that are not transmitted might, for instance, be varied dynamically between frames. The number of omitted columns may be signaled in various embodiments of the invention. It is further noted that, in various embodiments of the invention, the first omitted column or the address of the first omitted column could be signaled. The omitted columns might, for instance, be those columns that hold the least significant bytes of the parity data.

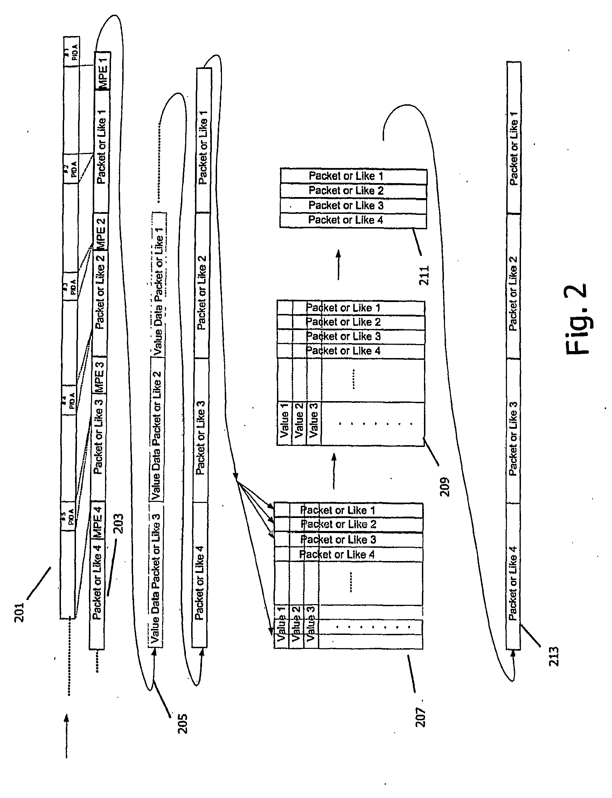

With respect to Fig. 2, it is noted the packets or the like just described might next arrive at a recipient node (step 205). It is noted that a recipient node might or not make use of characteristic values supplied by the transmitting node. For example, a recipient node might not be capable of making use of characteristic values. As another example, a user corresponding to a recipient node might specify, perhaps via a graphical user interface (GUI) or other interface, that characteristic values should not be employed by the node. As yet another example, a recipient node might, as will be discussed in greater detail below, make a determination as to whether or not characteristic values should be employed.

It is noted that a recipient terminal that, for instance, is incapable of making use of characteristic values, and/or has determined and/or received indication that it would not or might not make use of characteristic values, might, in various embodiments, act not to receive packets or the like dispatched by the transmitting node at all, or to receive them and to store some or all of them in a manner of its own choosing. The node might then make use of the received, perhaps modified, originally-loaded packets or the like in a conventional manner. The node might delete from storage received packets corresponding to characteristic values. It is noted that, in various such embodiments, the received packets corresponding to characteristic values might not be stored at all. Such packets might be recognized, for example, via an identifier such as PID (Program Identifier) or the like.

Alternately, such a recipient node might act to drop packets or the like holding characteristic values without storing them. The node could, in accordance with various embodiments, recognize such packets or the like in a number of ways. For example, such packets could be recognized by their headers. More specifically, the headers of such packets might specify, for instance, a different source IP address or the like than those specified by the headers of the, perhaps modified, originally-loaded packets or the like.

Where the recipient node had determined and/or received indication that it might make use of characteristic values, the node, perhaps after the storing received packets or the like in a manner of its own choosing, could perform appropriate actions to determine if the characteristic values would be employed. Such determination will be discussed in greater detail below. Where the recipient node determined and/or received indication that characteristic values were not to be employed, the node could act to, perhaps after storing the received packets or the like in a manner of its own choosing, make use of the received, perhaps modified, originally-loaded packets or the like in a conventional manner.

Where the recipient node determined and/or received indication that characteristic values were to be employed, the recipient node could create and/or access a two-dimensional array or the like corresponding to the array or the like created and/or accessed by the transmitting node. The array or the like created and/or accessed by the recipient node could, for example, possess in common with the array or the like created and/or accessed by the transmitting node one or more properties. For example, the array or the like created and/or accessed by the recipient node could be of the same size and/or be addressed in the same way as the array or the like created and/or accessed by the transmitting node.

In various embodiments, the transmitting node could, for example, dispatch to the recipient node an indication of properties relating to its created and/or accessed array or the like. Such properties could include, for example, array or the like column size, row size, addressing information, and/or the like. As another example, it could be established that indicated such properties be observed by all specified transmitting and recipient nodes. Such properties could, for instance, be set by a system administrator or the like.

Having performed any necessary steps to create and/or make accessible the array or the like, the recipient node could load into its array or the like the received packets or the like holding characteristic values and the, perhaps modified, originally-loaded packets or the like (step 207). The loading could be in accordance with any received row and/or column address indications of the sort noted above. Accordingly, through such loading, the array or the like of the recipient load could come to match the transmitting node's array or the like before it was emptied. It is noted that, in various embodiments, such address indications would not need to be received in order for the recipient node to be able to load its array or the like so as to match the transmitting node's array or the like before it was emptied. For instance, where multiprotocol encapsulation (MPE) is employed in transmission or the recipient node, the recipient node might employ transport stream (TS) continuity counter values in such loading of its array or the like.

In various embodiments of the invention, the receiver performs a CRC-32 check to the received data packet or section before the received data packet is stored in the array. When the result of the CRC-32 check shows that the section is correct the position of the data packet may be marked as 'reliable' and it may be put into the array starting at the address specified in the section header. The CRC-32 check may be done to the original data packets or like and/or to the sections that hold characteristic value data or parts thereof (e.g., RS code). In various embodiments of the invention the sections that do not qualify for the CRC-32 check may be left empty or may be filled with predetermine data to indicate a 'hole' in the frame. These 'holes' could be viewed as corresponding to lost sections and they could be marked as 'unreliable' in the RS decoding. In such embodiments, all byte positions could be appropriately marked as "reliable" or "unreliable", and an RS decoder could be able to correct the erroneous or unreliable bytes. As a specific example, in the case of the RS code having 64 parity bytes, the RS decoder could be able to correct up to 64 bytes per 255-byte codeword.

If there are more than 64 unreliable byte positions in a row the RS decoder might, in various embodiments, not be able to correct anything and, for instance, could output the byte errors without error correction. The receiver can therefore have perfect knowledge about the positions of any remaining byte errors within the frame after RS decoding. If a received packet of data or section is only partly corrected the receiver will be able to detect this and optionally discard this datagram.

Having effectively caused its array or the like to match the transmitting node's array or the like before it was emptied, the recipient node will have reassembled the above-noted characteristic values (step 209). As a next step, the recipient node could act to apply each of one or more of the characteristic values to its corresponding row in the array or the like (step 211). Such application could, for example, act to perform FEC with respect to received, perhaps modified, originally-loaded packets or the like.

It is noted that, in certain embodiments, not all characteristic values would be applied. For example, where there is more than one characteristic value per row, less than all of those values might be applied to that row. As another example, corresponding characteristic values might be applied to each of one or more certain rows, while no corresponding characteristic values might be applied to one or more other rows.

As a next step, the recipient node could act to unload its array or the like in a columnar-wise manner so as to extract the, perhaps modified and perhaps affected (e.g., corrected) in accordance with one or more characteristic values, originally-loaded packets or the like (step 213). The node could then make use of those extracted packets or the like in a conventional manner.

Although the foregoing has described the recipient node as affecting (e.g., correcting) the, perhaps modified, originally-loaded packets or the like as they are stored in the array or the like, it is noted that, in various embodiments, such application might be performed, for example with respect to such packets after their extraction from the array or the like. Moreover, it is noted that, in various embodiments, iterative use of characteristic values (e.g., Reed-Solomon data) could be performed at the receiver. For instance, turbo decoding could be employed. The performance of such turbo decoding, could involve, for example, repeated iterative of row-wise and columnar-wise use of characteristic values and/or data resulting from the application of those values. The iteration could also be performed between the proposed FEC decoding and some lower layer FEC decoding capable of delivering soft bit information.

Further, although the embodiments described herein may discuss the use of packets or the like, embodiments of the present invention are applicable in an analogous manner, for instance, to bit streams or the like. Still further, it is noted that although the embodiments described herein may discuss computation of characteristic values with respect to rows, other techniques might be employed. For instance, in various embodiments, characteristic values might be calculated in a zigzag form.

Additionally, although the embodiments described herein discuss columnar-wise loading of the array or the like, various embodiments of the present invention may act differently. For instance, such loading could be in an row-wise manner. The functionality for such embodiments would be analogous to those discussed herein, but with columnar operations being performed row-wise, and row-wise operations being performed in a columnar manner.

The characteristic values and sets of characteristic values may be computed by selecting a number of data elements from an array having data segments comprising one or more data elements placed in row-wise or column-wise in the array and applying the computation to the selected elements and placing the resulting characteristic value into one or more predetermined places reserved for characteristic values in the same or in another array. The selection of the data elements may comprise selecting all or some of the elements in one row or column. Other selection methods, such as, for example, selecting elements from one or more diagonals in the array (zigzag), may be used as well as selecting the data elements according to a prescribed pattern.

Further, in various embodiments, the data elements are selected from the array in a random manner, wherein the number of elements may be fixed and the random selection pattern is known to the transmitter and the receiver. In some embodiments of the invention all data elements in the array are not necessarily used in the computations, and in other embodiments of the invention some of the elements may be used more than one time in the computations for one or more characteristic values.

A specific exemplary embodiment of the present invention will now be described.

According to this exemplary embodiment, data to be transmitted is handled by a modified DVB encapsulator. The encapsulator has the capability of receiving IP packets carried over Ethernet frames and outputting TS packets.

As a first step in this exemplary embodiment, the modified encapsulator receives Ethernet frames sequentially. The encapsulator might act to arrange and/or drop frames based on, for example, Ethernet MAC address and/or IP packet address. Criteria could be predetermined, for instance, based on the nature of the data to be transmitted. In this step, Ethernet frame structure is removed.

As a next step, selected IP packets are placed into multiprotocol encapsulation (MPE) datagrams (e.g., DSM-CC (Digital Storage Media Command and Control) sections).

As a next step in this exemplary embodiment, IP datagrams are stored column-wise into a coding table or array. Each IP datagram's address in memory is stored in a header. For instance, an IP datagram's address in memory could be stored in the MAC (media access control) address bytes of its header. Time slice real-time parameters can inserted in this phase.

Next, after the desired amount, of IP datagrams have been stored into memory, FEC calculation is done row-wise. It is noted that, in the case where the IP datagrams are stored row-wise, rather than column-wise as just described, FEC is calculated column-wise. In either case, IP datagram storing and FEC calculation could be thought of as being opposed to one another at a 90 degree angle. It is also noted that IP datagrams could, alternatively, be transmitted in parallel of FEC calculation. In such a case, copies of IP datagrams could be left into memory to be used in FEC calculation.

Next, upon completion of all FEC calculations, calculated FEC bytes are placed into MPE sections. After this, all IP datagrams are placed into TS packet payloads. In this exemplary embodiment, IP datagrams are sent in TS packets with the same PID value. As an alternative, MPE sections carrying FEC data could be sent with TS packets that have other PID values than TS packets carrying IP packet data

Operations at a receiving node, in the case where the node acts to calculate FEC, will now be described in accordance with the specific exemplary embodiment of the present invention.

As a first step, the receiving node, perhaps after filtering desired TS packets (e.g., packets with PID value "A"), removes TS packet headers and forms IP datagrams from the TS packet payload data.

Next, the receiving node stores received IP datagrams into a decoding table or array. In doing so, the receiving node uses address values from IP datagram headers.

Next, the receiving node performs the FEC decoding for the received data. After this, corrected IP datagrams that contain IP packet data are stored, preferably into same interleaving memory. As a next step, the IP datagrams are processed sequentially, and the IP datagram headers and trailers are removed. The resultant IP packets are passed on for conventional use.

Operations at a receiving node, in the case where the node does not act to perform the FEC decoding, will now be described in accordance with the specific exemplary embodiment of the present invention.

As a first step, the receiving node, perhaps after filtering desired TS packets (e.g., packets with PID value "A"), removes TS packet headers and forms IP datagrams from the TS packet payload data.

Next, the receiving node stores IP datagrams into receiver memory, It is noted that the memory need not be a decoding table or array, and that the receiving node could instead act to store the data in a manner of its own choosing.

Next, the IP datagrams are processed sequentially, and the IP datagram headers and trailers are removed. The resultant IP packets are passed on for conventional use.

### Loading, Addressing, and Sizing of Two-Dimensional Arrays or the Like

A two-dimensional array or the like of the sort noted above could, in accordance with various embodiments of the present invention, be loaded in a number of ways. For example, in various embodiments where loading is to be columnar-wise, implementation could be such that only one packet or the like (e.g., IP packet) is loaded per column.

For such embodiments, array row and/or column size could be chosen such that a column would be capable of holding a maximally-sized packet or the like. In the case where a packet or the like loaded into a column was of less than the maximal size, the remaining portion of the column might be filled with "stuff data". As specific example, the remaining portion could be filled with zeros.

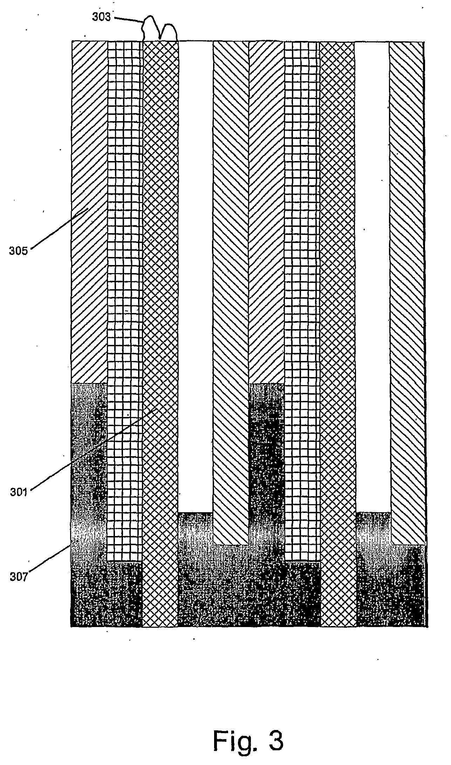

Shown in exemplary Fig. 3 is loading of the sort just described. In Fig. 3, exemplary packet or the like 301 is maximally sized, so no stuff data is added to the column 303 in which it resides. On the other hand, packet or the like 305 is of less than the maximal size, and, accordingly, stuff data 307 is added to its column such that the combination of packet or the like 305 and stuff data 307 occupies the entire column. It is also possible that one or more entire columns contain only stuff data. Such columns may be placed before, between, or after the columns containing data, or a combination of these may be used.

As another example of loading in various embodiments where loading is to be columnar-wise, implementation could be such that in the case where a packet or the like did not fully occupy the column into which it was loaded, loading of the column could continue with the next packet or the like to be loaded into the array or the like. Further, in the case where a packet being loaded into a column could not fully fit into that column, those portions which did not fit could be placed in one or more additional column.

Such functionality could be implemented, for example, in such a manner that where a particular packet or the like did not fully fit inside a column, the column would be filled with contents of the packet or the like up to the column's last addressable element (e.g., the element of the column having the highest row-wise address), and the remainder of the packet or the like could be placed in the following column, starting with that columns first addressable element (e.g., the element of the column having the lowest row-wise address).

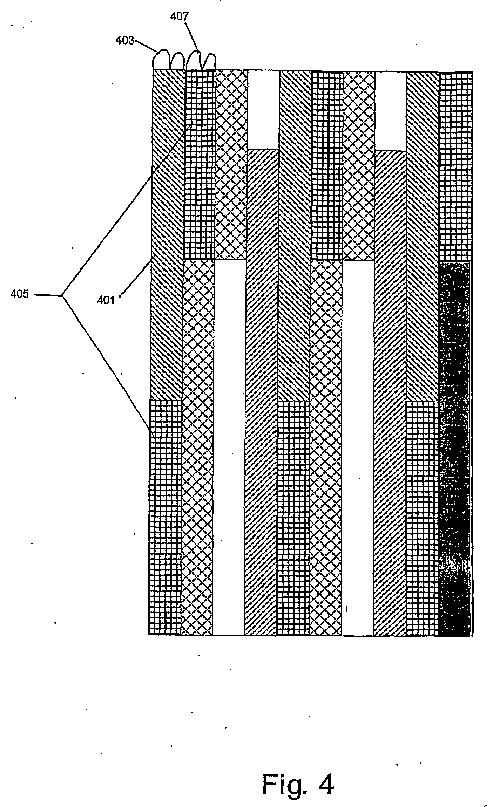

Shown in exemplary Fig. 4 is loading of the sort just described. In Fig. 4, exemplary packet or the like 401 is does not fully fill column 403 into which it was loaded, and the remainder of column 403 is accordingly filled with portions of packet or the like 405. However, as packet or the like 405 can not fully fit with in the portion of column 403 left unfilled by packet or the like 401, the remainder of that packet or the like is placed in column 407, starting, in this example, with the first element (e.g, the element of the column having the lowest row-wise address).

It is noted that, in various embodiments of the sort just described, stuff data might be placed between placed packets or the like. Such functionality might be implemented, for instance, with the goal of rounding out the lengths of packets or the like so that the length of a packet or the like and its associated stuff data would have, for instance, a length that was a whole wordlength (byte) multiple. For embodiments where such functionality was employed, addressing schemes for the corresponding array or the like could be simplified, as, for embodiments where loading was to be columnar-wise, row-wise addressing could be implemented with a whole-byte granularity. Also in embodiments of the sort described, it is possible to use full columns of stuff data either between the columns filled with data, before or after the columns filled with data, or via a combination of both those techniques.

It is noted that, for embodiments implementing loading in a manner where only one packet or the like is placed per column, indications of the sort noted above relating to where particular packets or the like were placed in the corresponding array or the like might, where loading was columnar, need only relate the columnar address corresponding to where in the array or the like the packet or the like was stored.

Implementation could, for example, be such that it would be understood at the recipient node that received packets or the like were to be placed in the first addressable element of the indicated column (e.g., the element of the column having the lowest row-wise address), and that unfilled portions of such a column were to be filled with stuff data. On the other hand it is noted that, for embodiments implementing loading in a manner where more than one packet or the like might placed per column, an indication of the sort noted above might need to specify both a row-wise and columnar address.

Turning to addressing, it is noted that, according to various embodiments of the present invention, an addressing scheme could be determined for an array or the like of the sort noted above. When thought of with respect to an array or the like of a particular size, selection of addressing scheme might be viewed as having the effect of determining the number of addressable elements in that array or the like.

It is further noted that, when thought of with respect to an array or the like of a particular size, selection of a row-wise addressing scheme might be viewed as having the effect of determining the number of rows in an array or the like of the sort noted above, while selection of a columnar-wise addressing scheme might be viewed as having the effect of determining the number of columns in an array or the like of the sort noted above. Still further, it is noted that selection of row-wise and columnar-wise addressing schemes might, when thought of with respect to an array or the like of a particular size, be thought of as selection of the size of each addressable element of the array or the like.

As a specific example, an array or the like of the sort noted above could be implemented so that both row and column addressing were implemented with one-byte granularity. As another specific example, where an array or the like of he sort noted above was to be loaded with data columnar-wise, columnar-wise addressing could be chosen so as to make maximal use of available address space. For instance, where 32-bit addressing was available, columnar addressing could be chosen so as to allow for the maximum possible number of columns, the determination perhaps taking into account the maximum size of data (e.g., IP packets) to be stored in the array or the like.

As yet another specific example where loading was to be columnar-wise, row-wise addressing could be implemented such that the resultant number of rows was optimized for channel error behavior. As still another specific example where loading was to be columnar-wise, row-wise addressing could be implemented such that the resultant number of rows would be consistent with the properties of a particular characteristic value determination (e.g., FEC) technique.

Turning to size, it is noted that selection of the size of an array or the like of the sort noted above could be approached in terms of selecting a row width and a column height for the array or the like. Size selection could, according to various embodiments of the present invention, be implemented in a number of ways. For example, where loading is to be columnar-wise, column height could be chosen to be consistent with the maximal size of a packet or the like of the sort to be loaded into the array or the like. Alternately, some other value might be chosen. Such choice might be performed, for example, by a system administrator or other individual.

The row width for a array or the like with a column height so chosen could be selected in a number of ways. For instance, the row width could be chosen by deciding upon a maximum number of packets or the like that would be allowed to be sent within a burst, and then determining the extra room in the array or the like that would be required for the corresponding characteristic value or values. For such embodiments, array or the like characteristics could be ' known by transmitting nodes and recipient nodes ahead of time. The width of an array may be chosen to comply with the selected method for computing characteristic values. The selected method can determine both the number of columns for data and the number of columns for characteristic values. As an example, the selection of Reed-Solomon encoding 255 can lead to 191 columns for data and 64 columns for characteristic values.

As another example where loading is to be columnar-wise, transmitting nodes could vary size of the array or the like for each burst dispatched. As a specific example, a transmitting node might select column height and row width in such that the corresponding array or the like could hold all of the packets or the like and any corresponding characteristic data to be transmitted within a particular burst. As another example, the transmitting node could act in a similar manner, but in accordance with a specified and/or fixed column height or row width. Where, for example, column height was specified, such column height might be consistent with the maximal size of a packet or the like of the sort to be loaded into the array or the like, or might be some other value. For embodiments, where column height and/or row width is not fixed, a transmitting node could, as alluded to above, dispatch to a recipient node one or more size indications. It is noted that in various embodiments where the size of the array or the like is fixed, in the case where less than all of the array or like is used, the transmitting node might send to a recipient node an indication of what portion of the array or the like is to be used. Such an indication might be, for example, an address.

In various exemplary embodiments of the invention, the data to be sent in one burst could be formed into a frame arranged as an array having, for instance, 255 columns and a flexible number of rows. The number of rows could be signaled in a descriptor in a header of the frame. In this example, the 191 leftmost columns could be reserved for OSI layer 3 datagrams (e.g., IP datagrams) and the remaining 64 columns could be reserved for parity information. The above-noted 191 columns might be called an "application data table", and the above-noted 64 columns might be called RS data table. Each position in the array might, for instance, contain one byte of information. Each such byte position could addressable by the number of the column and the number of the row. Some of the 191 leftmost columns might be filled with padding or stuffing (e.g. with zero bytes) in order to completely fill this part of the array if the datagrams do not fill the columns completely. The number of padding bytes might, perhaps, be signaled in the header of the frame. This signaling information might be used in various embodiments of the invention by the receiver for completing the array in the receiver.

With further regard to the example, it is noted that when all of the leftmost 191 columns are filled, it is possible to calculate for each row of the array 64 parity bytes from the 191 bytes of data and possible padding. The resulting parity bytes could be placed to the 64 rightmost columns. The code used for the calculation in this example is Reed-Solomon RS(255, 191, 64). Then each row of the array contains one RS codeword. When transmitting the frame, some or all of the columns in RS data table may be discarded and not transmitted, which corresponds to puncturing. In various exemplary embodiments of the invention, the number of punctured RS columns might not be signaled explicitly, and the number might be changed dynamically from frame to frame. It is further noted that, in various embodiments of the invention, the number of punctured RS columns might be calculated on the basis of a signaled number of the last section in the frame. In various embodiments of the invention this signaling information could be used by the receiver for completing the RS table. The puncturing could act to decrease the overhead that introduced by the RS data, and thus the bandwidth. A possible drawback of the puncturing could be a weaker code rate.

Each section of the application data table and/or of the RS data table could, in various embodiments, carry real time parameters comprising byte position addresses. The real time parameters for sections of the application data table and the RS data table might, for example, be carried within the MAC address fields of the corresponding sections. In various exemplary embodiments of the invention, the address field could specify the byte position for the first byte of the payload data carried within the section. In various embodiments, the sections could, for instance, be delivered in ascending order according to the value of the address. The bytes position might be a zero-based linear address within the application data and/or RS data table, starting from the first row of the first column, and increasing towards the end of the column. At the end of the column, the next byte position could be at the first row of the next column.

The first section carrying data of a frame, according to various embodiments, could be a section carrying the application data datagram at address "0" if the frame comprises application data only or application data and RS data. All sections carrying application data datagrams of a given frame might, in various embodiments, be transmitted prior to the first section carrying RS-data of the frame (e.g., sections carrying application data datagrams are not interleaved with sections carrying RS-data within a single frame). All sections carried between the first and the last section of the frame might, for instance, carry the data belonging to the frame (e.g., only application data and/or RS-data might be allowed). Sections delivering data of application data and RS data might, in various embodiments, not be interleaved. It is further noted that, in various embodiments, the datagrams in the application data table may not overlap.

The section following the last section carrying application data datagram on a frame according to the invention might, for example, contain either the first section carrying the RS-data of the same frame, or the first application data section of the next frame. In the later case, RS-data relating to the first frame might not transmitted.

According to various embodiments of the invention, for each frame might be transmitted exactly one application data section with address field set to value "0". Alternately or additionally, for each frame for which any RS data is transmitted, there might be transmitted exactly one RS data section with address field set to value "0". Addressing within the application data table and the RS data table might, in various embodiments, start preferably from zero. In various embodiments of the present invention, within delivered application data might be no padding or stuffing. Further, in various embodiments within delivered RS data in the RS table might be no padding or stuffing. Moreover, it is noted that, in various embodiments of the invention, when time slicing is used the frame comprising application data table and/or RS data table might be transmitted within one burst (e.g., the data of one frame might not be split over multiple bursts).

As alluded to above, although the foregoing has been discussed with respect to arrays or the like loaded columnar-wise, it is noted that in various embodiments loading could be row-wise, and that in such embodiments functionality could be analogous to that discussed above, but with row-wise aspects being columnar-wise and vice versa.

### Determination of Whether or Not Characteristic Data Should Be Employed

As alluded to above, according to various embodiments of the present invention, a recipient node might perform appropriate actions to determine if received characteristic values should be employed. Such actions might be performed, for example, in accordance with instructions placed by the node's user via, for instance, a GUI or other interface. Various schemes could be employable by a node for determining of characteristic values could be employed.

For example, in embodiments where received characteristic values corresponding to FEC or the like, a scheme could be employed wherein a recipient node would determine if there were errors in the received, perhaps modified, packets or the like originally-loaded by the corresponding transmitting node. The recipient node might, for example, employ CRC (Cyclic Redundancy Check) techniques in making the determination. In the case where errors were found, the recipient node might act to employ one or more of the received characteristic values. Also, other lower layer channel decoding may be used for determination. The use of lower layer channel decoding may also give indication of where errors are.

As another example for embodiments where loading of packets or the like is columnar-wise, where more than one characteristic value is determine for one or more rows, the recipient node might act to employ, for each of those rows, only one of the corresponding characteristic values. The recipient node might make such choice, for instance, in accordance with characteristics corresponding to detected error. Such characteristics might include, for example, error type, extent, and/or the like.

As yet another example for embodiments where loading of packets or the like is columnar-wise, the recipient node might choose to apply corresponding characteristic values with respect to certain rows but not others. As above, the recipient node might make such choice, for instance, in accordance with characteristics corresponding to detected error.

According to a further exemplary scheme, a recipient node might only act to employ received characteristic values if it determined that it had sufficient memory available. Having sufficient memory could, for instance, mean having sufficient memory to create and/or access an array or the like corresponding to the array or the like created and/or accessed by the corresponding transmitting node, and/or having sufficient memory to perform operations with regard to received characteristic values.

Performance of such a scheme could involve, for example, the recipient node consulting a specification of the required size for the array or the like, determining its amount of free and/or freeable memory, and determining if sufficient memory was available. As another example, performance of such a scheme could alternately or additionally involve the recipient node determining the amount of memory to perform operations with regard to received characteristic values. The specification of required size could, for example, be included in a dispatched indication of the sort noted above. As another example; the specification of required size could be in compliance with a size set to be employed for all arrays or the like as discussed above.

According to yet another exemplary scheme, a recipient node might only act to employ received characteristic values if it determined that there was sufficient energy (e.g., battery power) and/or available processing capacity to do so. Such functionality could be implemented in a number of ways. For example, a recipient node could make the above-noted determination of the type, extent, and/or the like of errors to be corrected. The node might next, perhaps taking into account the type or types of included characteristic data included (e.g., Reed-Solomon data), make an estimate of the necessary energy and/or available processing capacity to correct the errors. Viewing the estimate in light of determined available energy and/or processing capacity, the node could decide if there was sufficient energy and/or processing capacity to make use of the characteristic data.

The node could make the estimate, for example, by performing calculations using accessible algorithms, software modules, and/or the like. As another example, the node could make the estimate by consulting an accessible store that associated error types, error extents, and/or the like to be corrected with required energies and/or available processing capacities. The node could determine available energy and/or processing capacity, for instance, using functions provided by its operating system and/or loaded software modules.

According to yet another exemplary scheme, a recipient node might only act to employ received characteristic values for certain services, channels, data types, and/or the like. For instance, a recipient node might only act to employ received characteristic data for software and/or file downloads. A node's user might, in various embodiments, be able to specify the services, channels, data types, and/or the like for which received characteristic data should be employed. Further, in various embodiments, such might be specifiable by a system administrator or the like.

According to yet another exemplary scheme, a transmitting node may compute and employ characteristic values only for certain services, channels, data types, and/or the like.

### Encapsulation Operations

In various embodiments, MPE could be employed in various embodiments of the present invention. As also alluded to above, such MPE might, for example, be DSM-CC MPE. Information regarding MPE can be found, for example, in ETSI document TR 101 202, incorporated herein by reference. An exemplary use of MPE in accordance in embodiments of the present invention is shown in Fig. 1.

As shown in Fig. 1, a transmitting node could place into MPE DSM-CC sections packets or the like (e.g., IP packets) carrying data corresponding to computed characteristic values and/or, perhaps modified, originally-loaded packets or the like (e.g., IP packets) (step 109). As a next step, the DSM-CC sections could, for example, be placed in MPEG-2 TS packets (step 111). In various embodiments, a first PID value might be associated with TS packets carrying data corresponding to the, perhaps modified, originally-loaded packets or the like, while a second PID value might be associated with TS packets carrying data corresponding to characteristic values. The TS packets might next be transmitted over a link such as, for example, a DVB link.

Further, as shown in Fig. 2, a recipient node, having received TS packets of the sort noted above (step 201), could extract the DSM-CC sections carried by these packets (step 203). Next, the node could extract from those DSM-CC sections packets or the like (e.g., IP packets) carrying data corresponding to computed characteristic values and/or carried, perhaps modified, originally-loaded packets or the like (e.g., IP packets) (step 205).

Although DSM-CC MPE has been discussed here, it will be noted that other MPE techniques could be employed. It is further noted that although the foregoing has described implementation of MPE such that DSM-CC sections are not placed into the array or the like, in various embodiments DSM-CC sections carrying above-described packets or the like could be placed there.

In various embodiments of the invention, the data in the columns of the RS data table might be encapsulated by adding a header comprising one or more data fields before the transmission or delivery. These data fields might, for instance, be formed as such descriptors used in Network Information Tables (NITs) and/or IP/MAC Notification Tables (INTs). These descriptors could, for instance, identify whether time slicing and/or the frame according to the invention are used on an elementary stream. When these descriptors are used for specifying, the use of time slicing and/or the said frame, such might, in-various embodiments, be signaled in the Service Description Table (SDT) of the concerned service. The signaling might, for example, indicate that the MAC address bytes are used for another purpose than differentiating receivers. The descriptors might, in various embodiments, comprise data fields specifying the length of the descriptor, the use of time slicing, an indication on the use of the frame type according to the invention, the number of rows in the frame and the maximum duration of a burst, and/or the like.

When; for instance, the frame type according to the invention is used comprising application data table and RS data table, the sections containing RS data might, in various embodiments, comprise an indication on the length of the section, the number of full columns in the application data table filled with padding bytes only, a number of the section containing RS data, a number indicating the last section that carries RS data of the current frame, the RS data bytes, a CRC-32 check data calculated over the section, and/or the like. The numbering of the sections might, for instance, start from zero and/or be incremented by one for the next section carrying RS data.

### Hardware and Software

Certain procedures and the like described herein may be executed by or with the help of computers. The phrases "computer", "general purpose computer", and the like, as used herein, refer but are not limited to a processor card smart card, a media device, a personal computer, an engineering workstation, a PC,a Macintosh, a PDA, a computerized watch, a wired or wireless terminal, a server, a network access point, a network multicast point, or the like, perhaps running an operating system such as OS X, Linux, Darwin, Windows CE, Windows XP, Palm OS, Symbian OS, or the like, perhaps with support for Java or .Net.

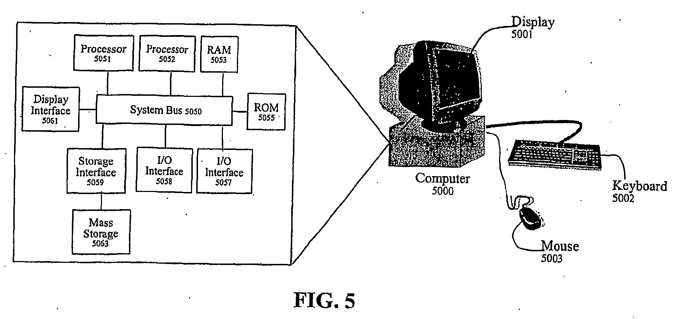

The phrases "general purpose computer", "computer", and the like also refer, but are not limited to, one or more processors operatively connected to one or more memory or storage units, wherein the memory or storage may contain data, algorithms, and/or program code, and the processor or processors may execute the program code and/or manipulate the program code, data, and/or algorithms. Accordingly, exemplary computer 5000 as shown in Fig. 5 includes system bus 5050 which operatively connects two processors 5051 and 5052, random access memory 5053, read-only memory 5055, input output (I/O) interfaces 5057 and 5058, storage interface 5059, and display interface 5061. Storage interface 5059 in turn connects to mass storage 5063. Each of I/O interfaces 5057 and 5058 may be an Ethernet, IEEE 1394, IEEE 1394b, IEEE 802.11a, IEEE 802.11b, IEEE 802.11g, IEEE 802.16a, IEEE P802.20, Bluetooth, terrestrial digital video broadcast (DVB-T), satellite digital video broadcast (DVB-S), digital audio broadcast (DAB), general packet radio service (GPRS), universal mobile telecommunications service (UMTS), or other interface known in the art.

Mass storage 5063 may be a hard drive, optical drive, or the like. Processors 5057 and 5058 may each be a commonly known processor such as an IBM or Motorola PowerPC, an AMD Athlon, an AMD Opteron, an Intel ARM, an Intel XScale, a Transmeta Crusoe, or an Intel Pentium. Computer 5000 as shown in this example also includes an display unit 5001, a keyboard 5002 and a mouse 5003. In alternate embodiments, keyboard 5002, and/or mouse 5003 might be replaced and/or augmented with a touch screen, pen, and/or keypad interface. Computer 5000 may additionally include or be attached to card readers, DVD drives, floppy disk drives, and/or the like whereby media containing program code may be inserted for the purpose of loading the code onto the computer.

In accordance with the present invention, a computer may run one or more software modules designed to perform one or more of the above-described operations. Such modules could be programmed using languages such as Java, Objective C, C, C#, and/or C++ according to methods known in the art. Corresponding program code might be placed on media such as, for example, DVD, CD-ROM, and/or floppy disk. It is noted that any described division of operations among particular software modules is for purposes of illustration, and that alternate divisions of operation may be employed. Accordingly, any operations discussed as being performed by one software module might instead be performed by a plurality of software modules. Similarly, any operations discussed as being performed by a plurality of modules might instead be performed by a single module.

Further, although embodiments of the invention may disclose certain software modules, tiers, and/or the like as operating on certain devices, in alternate embodiments these modules, tiers, and/or the like might be distributed to run on other devices than those stated. For example, operations disclosed as being performed by a particular computer might instead be performed by a plurality of computers. It is further noted that, in various embodiments, grid computing techniques may be employed.

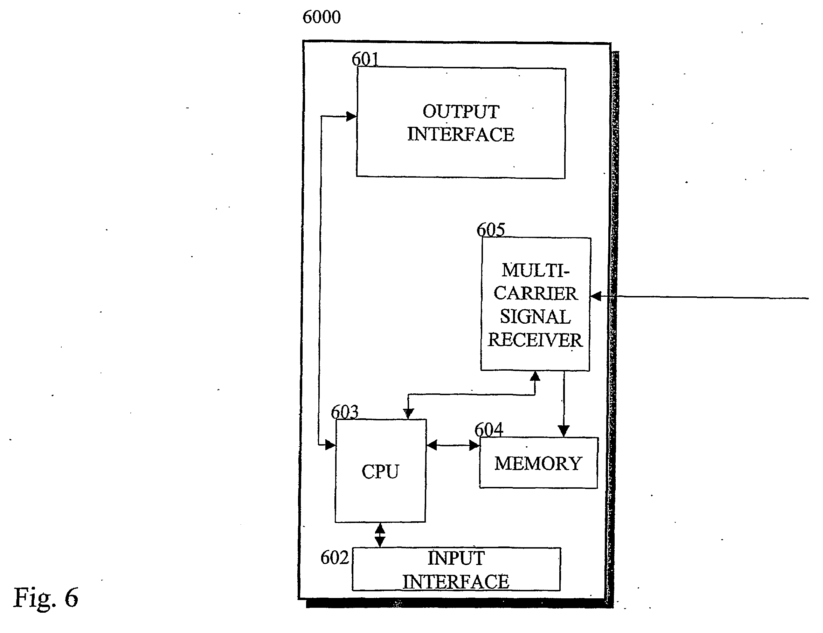

Shown in Fig. 6 is a functional block diagram of an exemplary terminal employable in various embodiments of the present invention. The terminal of Fig. 6 has been discussed in the foregoing. In the following, corresponding reference signs have been applied to corresponding parts. Terminal 6000 of Fig. 6 may be used in any/all of the embodiments described herein. The terminal 6000 comprises a processing unit CPU 603, a multi-carrier signal terminal part 605 and a user interface (601, 602). The multi-carrier signal terminal part 605 and the user interface (601, 602) are coupled with the processing unit CPU 603. One or more direct memory access (DMA) channels may exist between multi-carrier signal terminal part 605 and memory 604. The user interface (601, 602) comprises a display and a keyboard to enable a user to use the terminal 6000. In addition, the user interface (601, 602) comprises a microphone and a speaker for receiving and producing audio signals. The user interface (601, 602) may also comprise voice recognition (not shown).

The processing unit CPU 603 comprises a microprocessor (not shown), memory 604 and possibly software. The received data and the software can be stored in the memory 604. The microprocessor controls, on the basis of the software, the operation of the terminal 6000, such as the receiving of the data stream, the determination whether or not to use the characteristic data, the tolerance of the impulse burst noise in the data reception, rendering output in the user interface and the reading of inputs received from the user interface. The operations are described above. The hardware contains circuitry for detecting the signal, circuitry for demodulation, circuitry for detecting the impulse, circuitry for blanking those samples of the symbol where significant amount of impulse noise is present, circuitry for calculating estimates, circuitry for performing the determination the use of characteristic data and circuitry for performing the corrections of the corrupted data.

Still referring to Fig. 6, alternatively, middleware or software implementation can be applied. The terminal 6000 can be a hand-held device which the user can comfortably carry. Advantageously, the terminal 6000 can be a cellular mobile phone which comprises the multi-carrier signal terminal part 605 for receiving the multicast transmission stream. Therefore, the terminal 6000 may possibly interact with the service providers.

### Ramifications and Scope

Although the description above contains many specifics, these are merely provided to illustrate the invention and should not be construed as limitations of the invention's scope. Thus it will be apparent to those skilled in the art that various modifications and variations can be made in the system and processes of the present invention without departing from the spirit or scope of the invention.

### Preferred features

1. A method for data transmission, comprising:
   placing one or more data segments into a two-dimensional data structure having first directional arrangements and second directional arrangements, wherein said first directional arrangements are perpendicular to said second directional arrangements, and wherein placement is with respect to said first directional arrangements;
   adding to each of said second directional arrangements one or more corresponding computed characteristic values;
   transmitting the contents of one or more of said first directional arrangements that holds portions of said characteristic values; and
   transmitting said one or more data segments.
2. The method of feature 1, wherein transmitting said one or more data segments comprises transmitting the contents of each of said first directional arrangements that holds one or more of said data segments.
3. The method of feature 1, wherein said one or more data segments are transmitted prior to placing.
4. The method of feature 1, further comprising adding to each of said data segments a data structure placement indication.
5. The method of feature 1, wherein each data segment of a set of data segments holds the contents of one of said first directional arrangements that holds portions of said characteristic values.
6. The method of feature 5, wherein each data segment of said set of data segments is a packet.
7. The method of feature 6, wherein said packet is an internet protocol datagram.
8. The method of feature 5, wherein each data segment of said set of data segments is a multiprotocol encapsulation section.
9. The method of feature 5, further comprising adding to each data segment of said set of data segments a data structure placement indication.
10. The method of feature 1, wherein each of said first directional arrangements holds no more than one of said data segments.
11. The method of feature 1, wherein each of said first directional arrangements may hold more than one of said data segments or parts thereof.
12. The method of feature 1, wherein said data segments correspond to data to be transmitted within a single burst.
13. The method of feature 1, wherein said characteristic values are computed after all of said data segments have been placed in said data structure.
14. The method of feature 1, wherein computation of said characteristic values corresponds to channel encoding.
15. The method of feature 14, wherein said channel encoding is Reed-Solomon encoding.
16. The method of feature 1, wherein said first directional arrangements are columns and said second directional arrangements are rows.
17. The method of feature 1, wherein said first directional arrangements are rows and said second directional arrangements are columns.
18. The method of feature 1 wherein said data structure is an array.
19. The method of feature 1, wherein said data segments are packets.
20. The method of feature 19, wherein said packets are internet protocol datagrams.
21. The method of feature 1, wherein said data segments are multiprotocol encapsulation sections.
22. The method of feature 1, wherein transmission is via digital video broadcast.
23. The method of feature 1, wherein transmission is via universal mobile telecommunications service.
24. The method of feature 1, further comprising transmitting indications corresponding to properties of said data structure.
25. A method for data reception, comprising :
   receiving one or more data segments;
   placing the received data segments into a two-dimensional data structure having first directional arrangements and second directional arrangements, wherein said first directional arrangements are perpendicular to said second directional arrangements, and wherein placement is with respect to said first directional arrangements;
   applying to each of one or more of said second directional arrangements one or more corresponding received characteristic values, wherein said applying corrects one or more of said data segments; and
   extracting from said data structure one or more corrected data segments.
26. The method of feature 25, wherein placement is in compliance with received data structure placement indications.
27. The method of feature 25, wherein each of said first directional arrangements holds data corresponding to no more than one of said corrected data segments.
28. The method of feature 25, wherein each of said first directional arrangements may hold data corresponding to more than one of said corrected data segments.
29. The method of feature 25, wherein said corrected data segments correspond to data transmitted within a single burst.
30. The method of feature 25, wherein applying said characteristic values corresponds to channel decoding.
31. The method of feature 30, wherein said channel decoding is Reed-Solomon decoding.
32. The method of feature 25, wherein said first directional arrangements are columns and said second directional arrangements are rows.
33. The method of feature 25, wherein said first directional arrangements are rows and said second directional arrangements are columns.
34. The method of feature 25 wherein said data structure is an array.
35. The method of feature 25, wherein the received data segments are packets.
36. The method of feature 35, wherein said packets are internet protocol datagrams.
37. The method of feature 25, wherein the received data segments are multiprotocol encapsulation sections.
38. The method of feature 25, wherein the corrected data segments are packets.
39. The method of feature 38, wherein said packets are internet protocol datagrams.
40. The method of feature 25, wherein the corrected data segments are multiprotocol encapsulation sections.
41. The method of feature 25, wherein reception is via digital video broadcast.
42. The method of feature 25, wherein reception is via universal mobile telecommunications service.
43. The method of feature 25, wherein properties of said data structure are in compliance with received data structure property indications.
44. A method for data transmission, comprising:
   defining a two-dimensional data structure having first directional arrangements and second directional arrangements, wherein said first directional arrangements are perpendicular to said second directional arrangements, and wherein said data structure is divided, with respect to said first directional arrangements, into two or more data substructures;
   placing one or more data segments into a first of the data substructures, wherein placement is with respect to said first directional arrangements;
   computing, with respect to said second directional arrangements, one or more characteristic values for the placed data segments;
   placing the computed one or more characteristic values into a second of the data substructures, wherein placement is with respect to said second directional arrangements;
   transmitting, with respect to said first directional arrangements, the said one or more data segments from the first data substructure;
   selecting, with respect to said first directional arrangements, a number of data elements from the second data substructure, wherein the data elements are characteristic values or parts thereof; and
   transmitting the selected data elements.
45. The method of feature 44, wherein transmitting the selected data elements comprises encapsulating the selected data elements into a first format.
46. The method of feature 45, wherein encapsulating comprises adding data structure placement information.
47. The method of feature 44 further comprising adding data structure placement information to each of said data segments.
48. The method of feature 44, wherein defining said two-dimensional data structure comprises defining dimensions of said data structure with respect to said first directional arrangements and with respect to said second directional arrangements.
49. The method of feature 44, wherein said data structure is divided into two substructures.
50. The method of feature 44, wherein one or more of the data segments placed in the first data structure are padding data.
51. A system for data transfer comprising:
   at least one transmitter transmitting data and characteristic values; and
   at least one of:
      a receiver capable of receiving said data, but not capable of employing said characteristic values; and
      a receiver capable of receiving said data and said characteristic values, and capable of employing said characteristic values for reconstructing said data.
52. The system of feature 51, wherein said receiver capable of receiving said data, but not capable of employing said characteristic values employs a two-dimensional data structure for storage of said data.
53. The system of feature 51, wherein said receiver capable of receiving said data, but not capable of employing said characteristic values does not employ a two-dimensional data structure for storage of said data.
54. The system of feature 51, wherein said characteristic values correspond to parity data of channel encoding.
55. The system of feature 54, wherein said channel encoding is Reed-Solomon encoding.
56. A system for data transmission, comprising:
   a memory having program code stored therein; and
   a processor operatively connected to said memory for carrying out instructions in accordance with said stored program code;
   wherein said program code, when executed by said processor, causes said processor to perform the steps of:
      placing one or more data segments into a two-dimensional data structure having first directional arrangements and second directional arrangements, wherein said first directional arrangements are perpendicular to said second directional arrangements, and wherein placement is with respect to said first directional arrangements;
      adding to each of said second directional arrangements one or more corresponding computed characteristic values;
      transmitting the contents of one or more of said first directional arrangements that holds portions of said characteristic values; and
      transmitting said one or more data segments.
57. The system of feature 56, wherein transmitting said one or more data segments comprises transmitting the contents of each of said first directional arrangements that holds one or more of said data segments.
58. The system of feature 56, wherein said one or more data segments are transmitted prior to placing.
59. The system of feature 56, wherein said processor further performs the step of adding to each of said data segments a data structure placement indication.
60. The system of feature 56, wherein each data segment of a set of data segments holds the contents of one of said first directional arrangements that holds portions of said characteristic values.
61. The system of feature 60, wherein each data segment of said set of data segments is a packet.
62. The system of feature 61, wherein said packet is an internet protocol datagram.
63. The system of feature 60, wherein each data segment of said set of data segments is a multiprotocol encapsulation section.
64. The system of feature 60, wherein said processor further performs the step of adding to each data segment of said set of data segments a data structure placement indication.
65. The system of feature 56, wherein each of said first directional arrangements holds no more than one of said data segments.
66. The system of feature 56, wherein each of said first directional arrangements may hold more than one of said data segments or parts thereof.
67. The system of feature 56, wherein said data segments correspond to data to be transmitted within a single burst.
68. The system of feature 56, wherein said characteristic values are computed after all of said data segments have been placed in said data structure.
69. The system of feature 56, wherein computation of said characteristic values corresponds to channel encoding.
70. The system of feature 69, wherein said channel encoding is Reed-Solomon encoding.
71. The system of feature 56, wherein said first directional arrangements are columns and said second directional arrangements are rows.
72. The system of feature 56, wherein said first directional arrangements are rows and said second directional arrangements are columns.
73. The system of feature 56 wherein said data structure is an array.
74. The system of feature 56, wherein said data segments are packets.
75. The system of feature 74, wherein said packets are internet protocol datagrams.
76. The system of feature 56, wherein said data segments are multiprotocol encapsulation sections.
77. The system of feature 56, wherein transmission is via digital video broadcast.
78. The system of feature 56, wherein transmission is via universal mobile telecommunications service.
79. The system of feature 56, wherein said processor further performs the step of transmitting indications corresponding to properties of said data structure.
80. A system for data reception, comprising:
   a memory having program code stored therein ; and
   a processor operatively connected to said memory for carrying out instructions in accordance with said stored program code;
   wherein said program code, when executed by said processor, causes said processor to perform the steps of:
      receiving one or more data segments;
      placing the received data segments into a two-dimensional data structure having first directional arrangements and second directional arrangements, wherein said first directional arrangements are perpendicular to said second directional arrangements, and wherein placement is with respect to said first directional arrangements;
      applying to each of one or more of said second directional arrangements one or more corresponding received characteristic values, wherein said applying corrects one or more of said data segments; and
      extracting from said data structure one or more corrected data segments.
81. The system of feature 80, wherein placement is in compliance with received data structure placement indications.
82. The system of feature 80, wherein each of said first directional arrangements holds data corresponding to no more than one of said corrected data segments.
83. The system of feature 80, wherein each of said first directional arrangements may hold data corresponding to more than one of said corrected data segments.
84. The system of feature 80, wherein said corrected data segments correspond to data transmitted within a single burst.
85. The system of feature 80, wherein applying said characteristic values corresponds to channel decoding.
86. The system of feature 85, wherein said channel decoding is Reed-Solomon decoding.
87. The system of feature 80, wherein said first directional arrangements are columns and said second directional arrangements are rows.
88. The system of feature 80, wherein said first directional arrangements are rows and said second directional arrangements are columns.
89. The system of feature 80 wherein said data structure is an array.
90. The system of feature 80, wherein the received data segments are packets.
91. The system of feature 90, wherein said packets are internet protocol datagrams.
92. The system of feature 80, wherein the received data segments are multiprotocol encapsulation sections.
93. The system of feature 80, wherein the corrected data segments are packets.
94. The system of feature 93, wherein said packets are internet protocol datagrams.
95. The system of feature 80, wherein the corrected data segments are multiprotocol encapsulation sections.
96. The system of feature 80, wherein reception is via digital video broadcast.
97. The system of feature 80, wherein reception is via universal mobile telecommunications service.
98. The system of feature 80, wherein properties of said data structure are in compliance with received data structure property indications.
99. A system for data transmission, comprising:
   a memory having program code stored therein; and
   a processor operatively connected to said memory for carrying out instructions in accordance with said stored program code;
   wherein said program code, when executed by said processor, causes said processor to perform the steps of:
      defining a two-dimensional data structure having first directional arrangements and second directional arrangements, wherein said first directional arrangements are perpendicular to said second directional arrangements, and wherein said data structure is divided, with respect to said first directional arrangements, into two or more data substructures;
      placing one or more data segments into a first of the data substructures, wherein placement is with respect to said first directional arrangements;
      computing, with respect to said second directional arrangements, one or more characteristic values for the placed data segments;
      placing the computed one or more characteristic values into a second of the data substructures, wherein placement is with respect to said second directional arrangements;
      transmitting, with respect to said first directional arrangements, the said one or more data segments from the first data substructure;
      selecting, with respect to said first directional arrangements, a number of data elements from the second data substructure, wherein the data elements are characteristic values or parts thereof; and
      transmitting the selected data elements.
100. The system of feature 99, wherein transmitting the selected data elements comprises encapsulating the selected data elements into a first format.
101. The system of feature 100, wherein encapsulating comprises adding data structure placement information.
102. The system of feature 99 wherein said processor further performs the step of adding data structure placement information to each of said data segments.
103. The system of feature 99, wherein defining said two-dimensional data structure comprises defining dimensions of said data structure with respect to said first directional arrangements and with respect to said second directional arrangements. 104. The system of feature 99, wherein said data structure is divided into two substructures.
104. The system of feature 99, wherein said data structure is divided into two substructures.
105. The system of feature 99, wherein one or more of the data segments placed in the first data structure are padding data.
106. The method of feature 1, further comprising transmitting indication of properties of the two-dimensional data structure.
107. The method of feature 1, wherein stuff data is placed to fill remaining portions of one or more of said first directional arrangements.
108. The method of feature 1, wherein punctured first directional arrangements are not signaled explicitly.
109. The method of feature 1, wherein one or more first directional arrangements holding reed-solomon code data are omitted.
110. The method of feature 109, wherein number of omitted first directional arrangements holding reed-solomon code data changes dynamically from frame to frame.
111. The method of feature 1, wherein characteristic values are employed only for certain services.
112. The method of feature 1, wherein characteristic values are employed only for certain channels.
113. The method of feature 1, wherein characteristic values are employed only for certain data types.
114. The method of feature 1, wherein addressing of the two-dimensional data structure uses one-byte granularity.
115. The method of feature 1, wherein one or more portions of a data segment that does not fit into one of said first directional arrangements are placed into a subsequent one of said first directional arrangements.
116. The method of feature 1, wherein a header for a data segment includes indication of an address of a corresponding first occupied addressable storage location.
117. The method of feature 1, wherein one or more first directional arrangements containing only stuff data are placed adjacent to one or more first directional arrangements containing non-stuff data.
118. The method of feature 117, wherein a header specifies amount of stuff data.
119. The method of feature 25, wherein a position of a received data segment is marked as reliable.
120. The method of feature 25, further comprising filling unfilled portions of one or more first directional arrangements with stuff data.
121. The method of feature 25, wherein holes corresponding to lost sections are marked as unreliable.
122. The method of feature 25, further comprising determining a received data segment to be only partially corrected.
123. The method of feature 122, further comprising discarding the only partially corrected data segment.
124. The method of feature 25, wherein a reed-solomon decoder is employed to correct unreliable data.
125. The method of feature 25, further comprising performing a cyclic redundancy check on one or more of the received data segments.
126. The method of feature 25, further comprising performing a cyclic redundancy check on some or all of the characteristic values.
127. The method of feature 25, wherein characteristic values are employed only for certain services.
128. The method of feature 25, wherein characteristic values are employed only for certain channels.
129. The method of feature 25, wherein characteristic values are employed only for certain data types.
130. The method of feature 25, wherein addressing of the two-dimensional data structures uses one-byte granularity.
131. The method of feature 25, wherein one or more portions of a data segment that does not fit into one of said first directional arrangements are placed into a subsequent one of said first directional arrangements.
132. The method of feature 25, wherein a header for a data segment includes indication of an address of a corresponding first occupied addressable storage location.
133. The method of feature 25, wherein one or more first directional arrangements containing only stuff data are placed adjacent to one or more first directional arrangements containing non-stuff data.
134. The method of feature 133, wherein a header specifies amount of stuff data.
135. The method of feature 44, further comprising transmitting indication of properties of the two-dimensional data structure.
136. The method of feature 44, wherein stuff data is placed to fill remaining portions of one or more of said first directional arrangements.
137. The method of feature 44, wherein punctured first directional arrangements are not signaled explicitly.
138. The method of feature 44, wherein one or more first directional arrangements holding reed-solomon code data are omitted.
139. The method of feature 138, wherein number of omitted first directional arrangements holding reed-solomon code data changes dynamically from frame to frame.
140. The method of feature 44, wherein characteristic values are employed only for certain services.
141. The method of feature 44, wherein characteristic values are employed only for certain channels.
142. The method of feature 44, wherein characteristic values are employed only for certain data types.
143. The method of feature 44, wherein addressing of the two-dimensional data structure uses one-byte granularity.
144. The method of feature 44, wherein one or more portions of a data segment that does not fit into one of said first directional arrangements are placed into a subsequent one of said first directional arrangements.
145. The method of feature 44, wherein a header for a data segment includes indication of an address of a corresponding first occupied addressable storage location.
146. The method of feature 44, wherein one or more first directional arrangements containing only stuff data are placed adjacent to one or more first directional arrangements containing non-stuff data.
147. The method of feature 146, wherein a header specifies amount of stuff data.
148. The system of feature 56, wherein the processor further performs transmitting indication of properties of the two-dimensional data structure.
149. The system of feature 56, wherein stuff data is placed to fill remaining portions of one or more of said first directional arrangements.
150. The system of feature 56, wherein punctured first directional arrangements are not signaled explicitly.
151. The system of feature 56, wherein one or more first directional arrangements holding reed-solomon code data are omitted.
152. The system of feature 151, wherein number of omitted first directional arrangements holding reed-solomon code data changes dynamically from frame to frame.
153. The system of feature 56, wherein characteristic values are employed only for certain services.
154. The system of feature 56, wherein characteristic values are employed only for certain channels.
155. The system of feature 56, wherein characteristic values are employed only for certain data types.
156. The system of feature 56, wherein addressing of the two-dimensional data structure uses one-byte granularity.
157. The system of feature 56, wherein one or more portions of a data segment that does not fit into one of said first directional arrangements are placed into a subsequent one of said first directional arrangements.
158. The system of feature 56, wherein a header for a data segment includes indication of an address of a corresponding first occupied addressable storage location.
159. The system of feature 56, wherein one or more first directional arrangements containing only stuff data are placed adjacent to one or more first directional arrangements containing non-stuff data.
160. The system of feature 159, wherein a header specifies amount of stuff data.
161. The system of feature 80, wherein a position of a received data segment is marked as reliable.
162. The system of feature 80, wherein the processor further performs filling unfilled portions of one or more directional arrangements with stuff data.
163. The system of feature 80, wherein holes corresponding to lost sections are marked as unreliable.
164. The system of feature 80, wherein the processor further performs determining a received data segment to be only partially corrected.
165. The system of feature 164, wherein the processor further performs discarding the only partially corrected data segment.
166. The system of feature 80, wherein a reed-solomon decoder is employed to correct unreliable data.
167. The system of feature 80, wherein the processor further performs performing a cyclic redundancy check on one or more of the received data segments.
168. The system of feature 80, wherein the processor further performs performing a cyclic redundancy check on some or all of the characteristic values.
169. The system of feature 80, wherein characteristic values are employed only for certain services.
170. The system of feature 80, wherein characteristic values are employed only for certain channels.
171. The system of feature 80, wherein characteristic values are employed only for certain data types.
172. The system of feature 80, wherein addressing of the two-dimensional data structure uses one-byte granularity.
173. The system of feature 80, wherein one or more portions of a data segment that does not fit into one of said first directional arrangements are placed into a subsequent one of said first directional arrangements.
174. The system of feature 80, wherein a header for a data segment includes indication of an address of a corresponding first occupied addressable storage location.
175. The system of feature 80, wherein one or more first directional arrangements containing only stuff data are placed adjacent to one or more first directional arrangements containing non-stuff data.
176. The system of feature 175, wherein a header specifies amount of stuff data.
177. The system of feature 99, wherein the processor further performs transmitting indication of properties of the two-dimensional data structure.
178. The system of feature 99, wherein stuff data is placed to fill remaining portions of one or more of said first directional arrangements.
179. The system of feature 99, wherein punctured first directional arrangements are not signaled explicitly.
180. The system of feature 99, wherein one or more first directional arrangements holding reed-solomon code data are omitted.
181. The system of feature 180, wherein number of omitted first directional arrangements holding reed-solomon code data changes dynamically from frame to frame.
182. The system of feature 99, wherein characteristic values are employed only for certain services.
183. The system of feature 99, wherein characteristic values are employed only for certain channels.
184. The system of feature 99, wherein characteristic values are employed only for certain data types.
185. The system of feature 99, wherein addressing of the two-dimensional data structure uses one-byte granularity.
186. The system of feature 99, wherein one or more portions of a data segment that does not fit into one of said first directional arrangements are placed into a subsequent one of said first directional arrangements.
187. The system of feature 99, wherein a header for a data segment includes indication of an address of a corresponding first occupied addressable storage location.
188. The system of feature 99, wherein one or more first directional arrangements containing only stuff data are placed adjacent to one or more first directional arrangements containing non-stuff data.
189. The system of feature 188, wherein a header specifies amount of stuff data.

## Claims

1. A method, comprising:
receiving multiple data segments in a single burst;
determining to place the received data segments into a two-dimensional data structure corresponding to a multi-protocol encapsulation - forward error correction frame, wherein the two-dimensional data structure has first directional arrangements and second directional arrangements, wherein the first directional arrangements are perpendicular to the second directional arrangements, wherein the data structure is divided, with respect to the first directional arrangements, into two or more data substructures and wherein the placement is into a first of the data substructures and is with respect to the first directional arrangements;
determining to apply to each of one or more of the second directional arrangements one or more corresponding received channel encoding values, wherein the applying corrects one or more of the data segments; and
determining to extract from the data structure one or more corrected data segments,
wherein placement is in compliance with data structure placement indications received in the single burst, and wherein the data structure placement indications convey locations of the received data segments in the two-dimensional data structure.

2. A method according to claim 1, further comprising:
determining to receive data elements constituting the channel encoding values or parts thereof; and
determining to place the received data elements into a second of the data substructures, wherein the placement is with respect to the first directional arrangements.

3. A method according to claim 1 or 2, wherein a header for a data segment includes the data structure placement indication.

4. A method according to any preceding claim, wherein properties of the two-dimensional data structure are in compliance with received data structure property indications.

5. A method according to any preceding claim, wherein a header specifies an amount of stuff data and the method further comprises determining to place one or more first directional arrangements containing only stuff data adjacent to one or more first directional arrangements containing non-stuff data.

6. A method according to any preceding claim, wherein channel encoding values are employed only for certain services, certain channels or certain data types.

7. A method, comprising:
defining a two-dimensional data structure corresponding to a multi-protocol encapsulation - forward error correction frame, wherein the two-dimensional data structure has first directional arrangements and second directional arrangements, wherein the first directional arrangements are perpendicular to the second directional arrangements, and wherein the data structure is divided, with respect to the first directional arrangements, into two or more data substructures;
determining to place multiple data segments into a first of the data substructures, wherein the placement is with respect to the first directional arrangements;
computing, with respect to the second directional arrangements, one or more channel encoding values for the placed data segments;
determining to place the computed one or more channel encoding values into a second of the data substructures, wherein the placement is with respect to the second directional arrangements;
determining to add to each of the multiple data segments from the first data substructure a data structure placement indication conveying a location of the data segment in the two-dimensional data structure;
determining to transmit in a single burst, with respect to the first directional arrangements, the multiple data segments from the first data substructure to which the data structure placement indications have been added;
determining to select, with respect to the first directional arrangements, a number of data elements from the second data substructure, wherein the data elements are channel encoding values or parts thereof; and
determining to transmit the selected data elements.

8. A method according to claim 7, further comprising determining to transmit indications corresponding to properties of the two-dimensional data structure.

9. A method according to claim 7 or 8, wherein one or more of the data segments placed into the first data substructure are stuff data and the method further comprises determining to specify the amount of stuff data in a header.

10. A method according to any one of claims 7 to 9, wherein the selected number of data elements changes dynamically from frame to frame.

11. An apparatus, comprising:
at least one processor; and
at least one memory including computer program code;
wherein the computer program code, when executed by the at least one processor, causes the at least one processor at least to perform:
defining a two-dimensional data structure corresponding to a multi-protocol encapsulation - forward error correction frame, wherein the two-dimensional data structure has first directional arrangements and second directional arrangements, wherein the first directional arrangements are perpendicular to the second directional arrangements, and wherein the data structure is divided, with respect to the first directional arrangements, into two or more data substructures;
determining to place multiple data segments into a first of the data substructures, wherein the placement is with respect to the first directional arrangements;
computing, with respect to the second directional arrangements, one or more channel encoding values for the placed data segments;
determining to place the computed one or more channel encoding values into a second of the data substructures, wherein the placement is with respect to the second directional arrangements;
determining to add to each of the multiple data segments from the first data substructure a data structure placement indication conveying a location of the data segment in the two-dimensional data structure;
determining to transmit in a single burst, with respect to the first directional arrangements, the multiple data segments from the first data substructure to which the data structure placement indications have been added;
determining to select, with respect to the first directional arrangements, a number of data elements from the second data substructure, wherein the data elements are channel encoding values or parts thereof; and
determining to transmit the selected data elements.

12. Apparatus according to claim 11, wherein the computer program code, when executed by the at least one processor, causes the at least one processor to further perform determining to transmit indications corresponding to properties of the two-dimensional data structure.

13. An apparatus, comprising:
at least one processor; and
at least one memory including computer program code;
wherein the computer program code, when executed by the at least one processor, causes the at least one processor at least to perform:
receiving multiple data segments in a single burst;
determining to place the received data segments into a two-dimensional data structure corresponding to a multi-protocol encapsulation - forward error correction frame, wherein the two-dimensional data structure has first directional arrangements and second directional arrangements, wherein the first directional arrangements are perpendicular to the second directional arrangements, wherein the data structure is divided, with respect to the first directional arrangements, into two or more data substructures and wherein the placement is into a first of the data substructures and is with respect to the first directional arrangements;
determining to apply to each of one or more of the second directional arrangements one or more corresponding received channel encoding values, wherein the applying corrects one or more of the data segments; and
determining to extract from the data structure one or more corrected data segments,
wherein placement is in compliance with data structure placement indications received in the single burst, and wherein the data structure placement indications convey locations of the received data segments in the two-dimensional data structure.

14. Apparatus according to claim 13, wherein the computer program code, when executed by the at least one processor, causes the at least one processor to further perform:
determining to receive data elements constituting the channel encoding values or parts thereof; and
determining to place the received data elements into a second of the data substructures, wherein the placement is with respect to the first directional arrangements.

15. Apparatus according to claim 13 or 14, wherein a header for a data segment includes the data structure placement indication.
